# EUROPEAN PATENT APPLICATION

(11) **EP 1 172 938 A1**
(43) Date of publication of application: **16.01.2002**
(21) Application number: 00904014.8
(22) Date of filing: 17.02.2000
(51) Int. Cl.: H04B 1/26, H04B 1/16, H03J 7/02

(54) **DIGITAL BROADCAST RECEIVER**

(71) Applicant: MITSUBISHI DENKI KABUSHIKI KAISHA, Tokyo 100-8310 (JP)
(72) Inventor: TAKEUCHI, Mitsuru, Mitsubishi Denki K.K., Tokyo 100-8310 (JP); MORITA, Masakazu, Mitsubishi Denki K.K., Tokyo 100-8310 (JP)
(74) Representative: HOFFMANN - EITLE
(86) International application number: JP0000909
(87) International publication number: WO0161874

(57) **Abstract**

At the initial start-up, a system controller (10) uses error information corresponding to the previous receive frequency, which is stored in a memory (14), to correct an initial value corresponding to the initial voltage value for the initial start-up, which is stored in a memory (9). A control voltage converter circuit (15) converts the corrected initial value to an initial voltage value, and a D/A converter (11) supplies the analog initial voltage value after conversion to a voltage controlled crystal oscillator (12) to oscillate the oscillation frequency for the initial start-up. The control voltage value used except at the time of start-up is generated and supplied to the voltage controlled crystal oscillator (12) by the automatic frequency controller (8). At the end of the reception, the error information obtained in the automatic frequency controller (8) is stored in the memory (14) under the control of the system controller (10).

## Description

### Background of the Invention

### Technical Field

This invention is related to a digital broadcasting receiver having an automatic frequency controller (AFC).

### Background Art

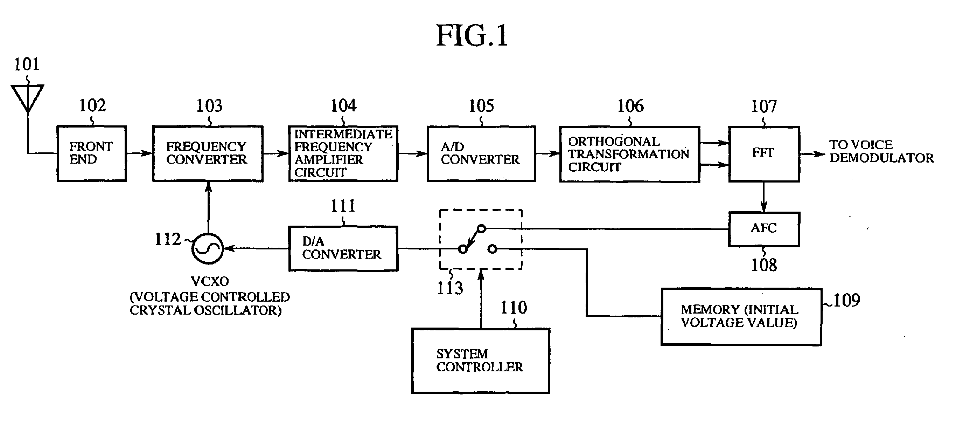

Fig. 1 is a block diagram showing a conventional digital broadcasting receiver, and in the figure, 101 is an antenna, 102 is a front end, 103 is a frequency converter, 104 is an intermediate amplifier circuit, 105 is an analog-to-digital (A/D) converter, 106 is an orthogonal transformation circuit, 107 is a fast Fourier transform (FFT) circuit, 108 is an automatic frequency controller (AFC), and 109 is a memory in which an initial voltage value is stored. 110 is a system controller, 111 is a digital-to-analog (D/A) converter, 112 is a voltage controlled crystal oscillator (VCXO), and 113 is a selector switch.

Now, the operation is described.

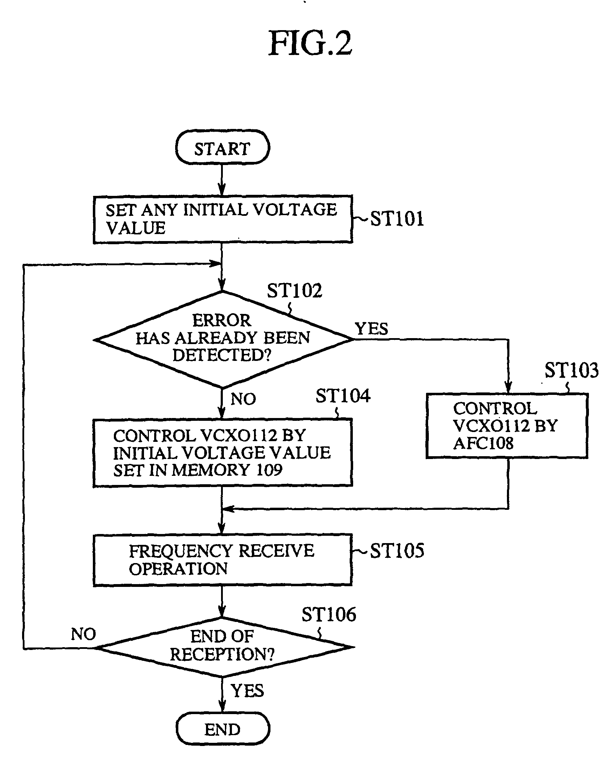

Fig. 2 is a flowchart showing the operation of the conventional digital broadcasting receiver shown in Fig. 1.

The receive frequency received through the antenna 101 is sent to the frequency converter 103 via the front end 102. The frequency converter 103 converts the desired broadcast wave within the receive frequency to an intermediate frequency. And, the intermediate frequency amplifier circuit 104 filters and amplifies the desired broadcast wave converted to the intermediate frequency, which is output from the frequency converter 103. Thereafter, digitized in the A/D converter 105, the desired broadcast wave is transformed in the orthogonal transformation circuit 106, and sent to the fast Fourier circuit 107. The fast Fourier transform circuit 107 performs a fast Fourier transform processing for the signal output from the orthogonal transformation circuit 106 into separate various data such as control data used for tuning the receive frequency, image data, and voice data. For instance, voice data separated in the fast Fourier transform circuit 107 is output to a voice demodulator (not shown). On the other hand, control data used for tuning the receive frequency is output to the automatic frequency controller 108.

As shown in the flowchart of Fig. 2, in the memory 109 of the digital broadcasting receiver, any initial voltage value is set (step ST101). When the automatic frequency controller 108 receives the control data for tuning the receive frequency that was output from the fast Fourier transform circuit 107, the system controller 110 checks whether or not an error of the receive frequency has already been detected by the automatic frequency controller 108 (step ST102), and if already detected, the process flows to step ST103.

In step ST103, the system controller 110 connects the automatic frequency controller 108 and the D/A converter 111 through the selector switch 113. This allows the automatic frequency controller 108 to determine a control voltage value based on the detected frequency error, and the determined control voltage value is converted to an analog value by the D/A converter 111, and output to the voltage control crystal oscillator 112. And, the process flows to step ST105 to continue the frequency receive operation.

On the other hand, in the checking in step ST102, if power has been just turned on, no frequency error was detected by the automatic frequency controller 108, and thus, the system controller 110 connects the memory 109 storing the initial voltage value and the D/A converter 111 through the selector switch 113. This allows the initial voltage value set in the memory 109 to be converted to an analog voltage value by the D/A converter 111, and supplied to the voltage controlled crystal oscillator 112. And, the process flows to step ST105.

In step ST105, frequency receive operation is continually performed, and in step ST106, a check is made as to whether or not the receive operation has ended. If the receiving has not ended, the process flow returns to step ST102 to repeat the processing in step ST103, step ST105, and step ST106.

Thus, the conventional digital broadcasting receiver has the construction as shown in Fig. 1, in which the system controller 110 and the automatic frequency controller 108 control the voltage supplied to the voltage controlled crystal oscillator 112 as a local oscillator, thereby changing the frequency oscillated in the voltage controlled crystal oscillator 112 to tune the receive frequency. And, at the initial start-up stage such as the timing at which power has been just turned on, the frequency oscillation operated at the voltage controlled crystal oscillator 112 is controlled by use of the initial voltage value (fixed value) preliminarily stored in the memory 109. After the detection of frequency error, the selector switch 113 is changed to the automatic frequency controller 108 side by the control of the system controller 110, and using the control voltage value that is output from the automatic frequency controller 108, the control of the oscillation frequency of the voltage controlled crystal oscillator 112 is carried out.

However, in the conventional digital broadcasting receiver having the construction shown in Fig. 1, the initial starting is carried out using the initial voltage value (fixed value) stored in the memory 109, and thus, there is a problem that the starting may be performed with a frequency largely different from the receive frequency of the signal obtained through the antenna 101, due to variation in the oscillation frequency oscillated in the voltage controlled crystal oscillator 112, so that some time is taken to start the digital broadcasting receiver.

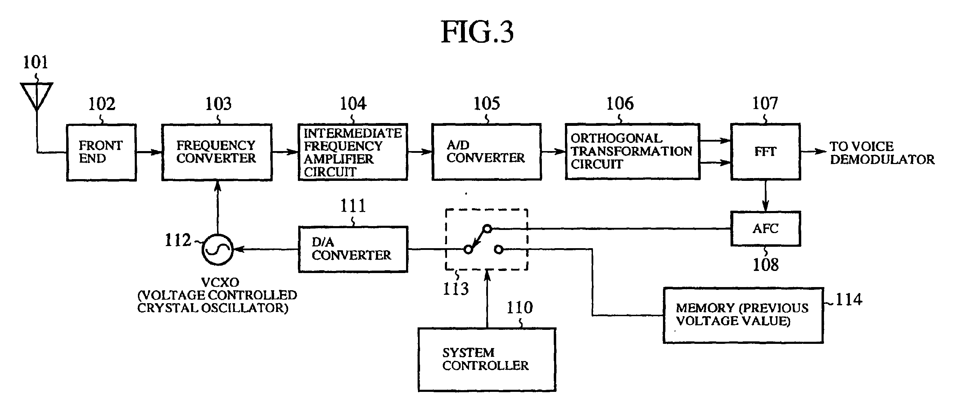

Fig. 3 is a block diagram showing another conventional digital broadcasting receiver, which is disclosed in the Patent Application Laid-Open No. 10-98355. In the figure, 114 is a memory for storing the control voltage value at the previous reception. The other structural elements are the same as those of the conventional digital broadcasting receiver shown in Fig 1, so the description of them is omitted here.

The operation is described below.

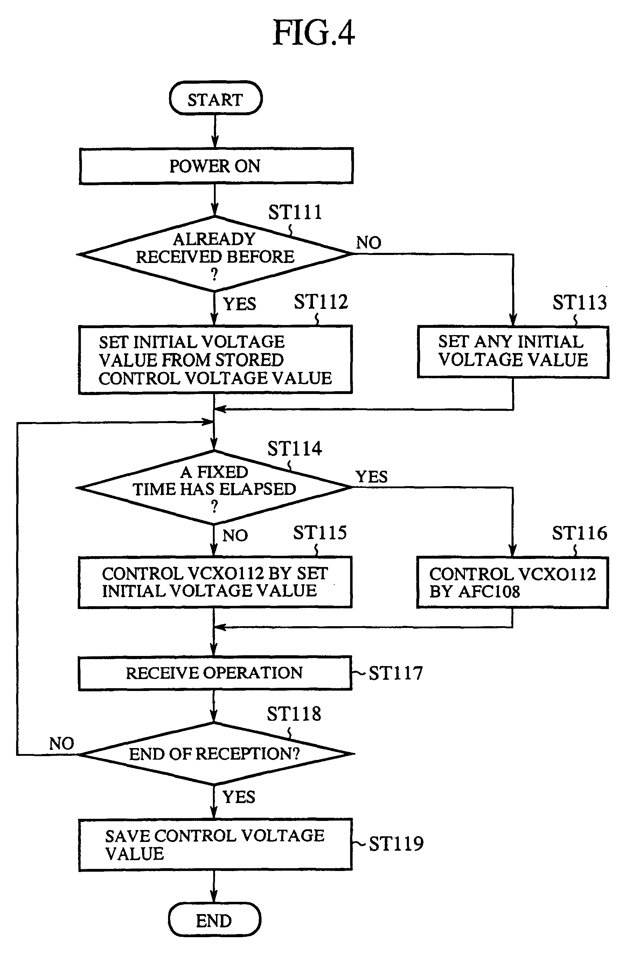

Fig. 4 is a flowchart showing the operation of the conventional digital broadcasting receiver shown in Fig. 3. The operation is the same as the conventional digital broadcasting receiver shown in Fig. 1 in the point that the receive frequency received via the antenna 101 is sent through the front end 102, frequency converter 103, intermediate frequency amplifier circuit 104, A/D converter 105, and orthogonal converter 106 to the fast Fourier transform circuit 107, and that the automatic frequency controller 108 inputs control data used for tuning the receive frequency that is output from the fast Fourier transform circuit 107.

In the conventional digital broadcasting receiver having the construction shown in Fig. 3, the control voltage value for frequency tuning in the previous reception is stored in the memory 114, and the control voltage value stored in the memory 114 is read out to perform the start-up again. And, after the elapse of a predetermined time from the starting, the selector switch 113 is changed to the control voltage value output from the automatic frequency controller 108 under the control of the system controller 110, thereby varying the oscillation frequency of the voltage controlled crystal oscillator 112. Note that if the power has not been turned on even once, as the control voltage for the previous reception does not exist in the memory 114, as does the initial voltage value to be set in the memory 109 in the conventional digital broadcasting receiver shown in Fig. 1, an initial value (fixed value) has been stored instead.

However, in the conventional digital broadcasting receiver having the construction shown in Fig. 3, although the variation in the oscillation frequency by the voltage controlled crystal oscillator 112 are dissolved, there is a problem that, if a change occurs in the receiving state of the digital broadcasting receiver, for instance, the receiving state such as the standstill state or the running state of a mobile unit such as a vehicle on which the digital broadcasting receiver is mounted, the control voltage value for the frequency tuning in the previous receive state cannot be used, and the start-up requires a longer time.

This invention was accomplished to solve the above described problem, and its object is to obtain a digital broadcasting receiver in which the initial starting time is shortened independently of variation in the receive state, and which can be promptly started even if the previous receive state and the current receiving state are different.

### Disclosure of Invention

The digital broadcasting receiver related to this invention is characterized by comprising a local oscillator for varying the oscillation frequency according to a supplied control voltage value, an automatic frequency controller for generating the control voltage value according to a receive frequency to tune to the receive frequency, and outputting it to the local oscillator, memory means for storing error information of the previously received receive frequency and an initial value according to the initial voltage value for the initial starting, and control means for reading out the error information and the initial value which are stored in the memory means, correcting the initial value based on the error information, generating the initial voltage value for starting based on the corrected initial value, outputting the generated initial voltage value to the local oscillator, and accessing the memory means at the end of the reception to store the error information according to the receive frequency generated in the automatic frequency controller in the memory means.

In the digital broadcasting receiver related to this invention, the memory means store the carrier error of the previously received receive frequency and an initial value according to the initial voltage value for the initial starting. Further, the control means reads out the carrier error and the initial value which are stored in the memory means at the time of start-up, corrects the initial value based on the carrier error, generates the initial voltage value for starting based on the corrected initial value, and outputs the generated initial voltage value to the local oscillator. Furthermore, it is characterized in that the control means accesses the memory means at the end of the reception to store the carrier error according to the receive frequency generated in the automatic frequency controller in the memory means.

In the digital broadcasting receiver related to this invention, the memory means store the carrier error and phase error of the previously received receive frequency, and an initial value according to the initial voltage value for the initial starting. Further, the control means reads out the carrier error, the phase error and the initial value which are stored in the memory means at the time of start-up, corrects the initial value based on the carrier error and the phase error, generates the initial voltage value for starting based on the corrected initial value, and outputs the generated initial voltage value to the local oscillator. Furthermore, it is characterized in that the control means accesses the memory means at the end of the reception to store the carrier error and the phase error for the receive frequency generated in the automatic frequency controller in the memory means.

In the digital broadcasting receiver related to this invention, the memory means store the carrier error, phase error and moving speed information of the previously received receive frequency, and an initial value according to the initial voltage value for the initial starting. Further, the control means reads out the carrier error, the phase error, the moving speed information and the initial value which are stored in the memory means at the time of start-up, corrects the initial value based on the carrier error, the phase error and the moving speed information, generates the initial voltage value for starting based on the corrected initial value, and outputs the generated initial voltage value to the local oscillator. Furthermore, it is characterized in that the control means accesses the memory means at the end of the reception to store the carrier error, the phase error and the moving speed information for the receive frequency generated in the automatic frequency controller in the memory means.

In the digital broadcasting receiver related to this invention, the memory means store a voltage value according to the carrier error of the previously received receive frequency, a voltage value according to the phase error, and a voltage value according to the moving speed information, and the initial voltage value for the initial starting. Further, the control means reads out the voltage value according to the carrier error, the voltage value according to the phase error, the voltage value according to the moving speed information, and the initial voltage value, which are stored in the memory means, corrects the initial voltage value based on the voltage value according to the carrier error, the voltage value according to the phase error, and the voltage value according to the moving speed information, and outputs the obtained initial voltage value to the local oscillator.

Furthermore, it is characterized in that the control means accesses the memory means at the end of reception to store the voltage value corresponding to the carrier error for the receive frequency generated in the automatic frequency controller, the voltage value corresponding to the phase error, and the voltage value corresponding to the moving speed information in the memory means.

### Brief Description of Drawings

Fig. 1 is a block diagram showing a conventional digital broadcasting receiver.
Fig. 2 is a flowchart showing the operation of the conventional digital broadcasting receiver shown in Fig. 1.
Fig. 3 is a block diagram showing another conventional digital broadcasting receiver.
Fig. 4 is a flowchart showing the operation of the conventional digital broadcasting receiver shown in Fig. 3.
Fig. 5 is a block diagram showing the digital broadcasting receiver according to a first embodiment of the present invention.
Fig. 6 is a flowchart showing the operation of the digital broadcasting receiver shown in Fig. 5.
Fig. 7 is a block diagram showing the digital broadcasting receiver according to a second embodiment of the present invention.
Fig. 8 is a flowchart showing the operation of the digital broadcasting receiver shown in Fig. 7.
Fig. 9 is a block diagram showing the digital broadcasting receiver according to a third embodiment of the present invention.
Fig. 10 is a flowchart showing the operation of the digital broadcasting receiver shown in Fig. 9.
Fig. 11 is a block diagram showing the digital broadcasting receiver according to a fourth embodiment of the present invention.
Fig. 12 is a flowchart showing the operation of the digital broadcasting receiver shown in Fig. 11.
Fig. 13 is a block diagram showing the digital broadcasting receiver according to a fifth embodiment of the present invention.
Fig. 14 is a flowchart showing the operation of the digital broadcasting receiver shown in Fig. 12.
Fig. 15 is an explanatory view showing the carrier shift operation.

### Best Mode for Carrying Out the Invention

Now, to describe this invention in more detail, the best mode for carrying out this invention is described according to the accompanying drawings.

### First Embodiment

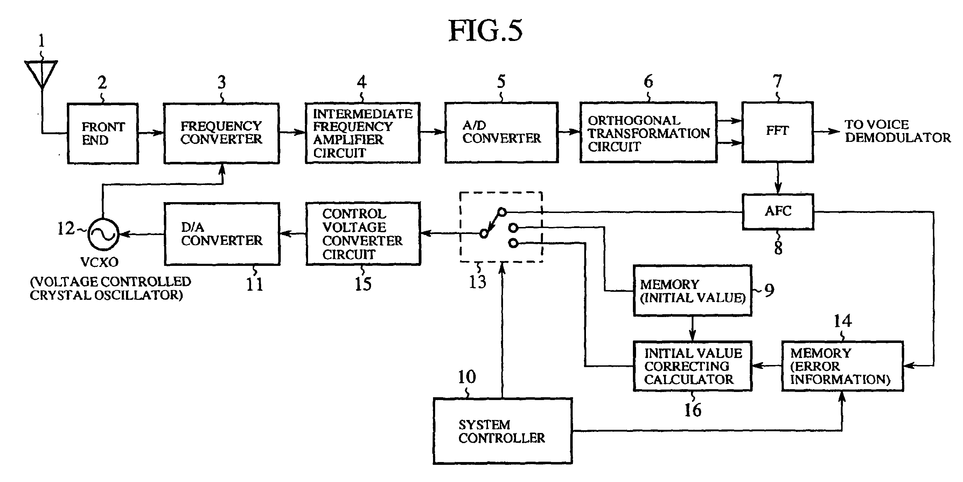

Fig. 5 is a block diagram showing the digital broadcasting receiver according to the first embodiment of the present invention, and in the figure, 1 is an antenna, 2 is a front end, 3 is a frequency converter, 4 is an intermediate frequency amplifier circuit, 5 is an analog-to-digital (A/D) converter, 6 is an orthogonal transformation circuit, 7 is a fast Fourier transform circuit (FET), 8 is an automatic frequency controller (AFC), and 9 is a memory in which an initial value for the control voltage value is stored. Further, 10 is a system controller, 11 is a digital-to-analog (D/A) converter, 12 is a voltage controlled crystal oscillator (VCXO), 13 is a selector switch, 14 is a memory for storing each error information such as carrier error, frequency error, time error, Doppler shift error, and moving speed information, 15 is a control voltage converter circuit, and 16 is an initial value correcting calculator.

The operation is described below.

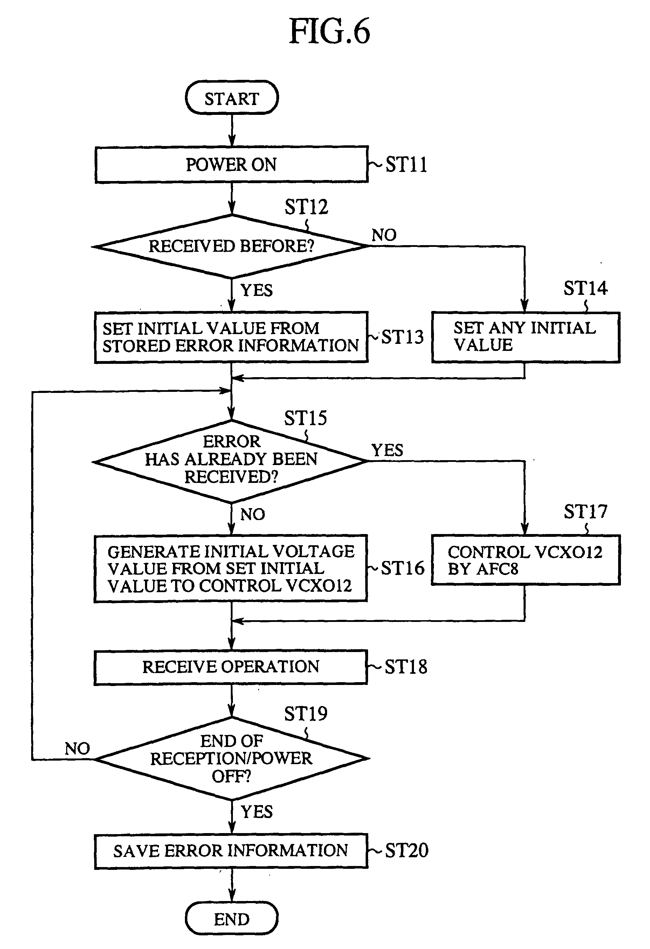

Fig. 6 is a flowchart showing the operation of the digital broadcasting receiver according to the first embodiment, which is shown in Fig. 5.

The power of the digital broadcasting receiver is turned on (step ST11), and a receive frequency is obtained through the antenna 1, and output through the front end 2, the frequency converter 3, the intermediate frequency amplifier circuit 4, the analog-to-digital (A/D) converter 5, and the orthogonal transformation circuit 6 to the fast Fourier transform circuit 7. And, the operation until the automatic frequency controller 8 inputs control data for tuning the receive frequency that is output from the fast Fourier transform circuit 7 is the same as the conventional digital broadcasting receiver shown in Figs. 1 and 3.

Then, in step ST12, by the system controller 10, a check is made as to whether or not the digital broadcasting receiver has received a receive frequency. That is, at the initial start-up time, for instance, when the power is turned on, if no receive frequency has been received before, the process flows to step ST14.

In step ST14, the system controller 10 connects the memory 9 and the control voltage converter circuit 15 through the selector switch 13 to output a given initial value previously stored in the memory 9 to the control voltage converter circuit 15 (step ST14).

On the other hand, in the check in step ST12, at the initial start-up time, for instance, when the power is turned on, if a frequency has been received before, the process flows to step ST13. In step ST13, the system controller 10 connects the initial value correcting calculator 16 and the control voltage converter circuit 15 through the selector switch 13, and also accesses the memory 14 so that the error information already stored in the memory 14 can be input to initial value correcting calculator 16. This allows the initial value output from the memory 9 and the error information obtained from the memory 14 to be input to the initial value correcting calculator 16, which corrects the initial value in the memory 9 based on the error information to calculate a new initial value (step ST13).

In the next step ST15, it is checked whether or not an error has been detected by the automatic frequency controller 8. In this case, it is the initial start-up time and no error has been detected by the automatic frequency controller 8, so the process flows to step ST16.

The control voltage converter circuit 15 has input thereto the initial value output from the memory 9 or the initial value output from the initial value correcting calculator 16 via the selector switch 13, and converts the initial value to an initial voltage value. Thereafter, the initial voltage value, converted to an analog value by the D/A converter 11, is output to the voltage controlled crystal oscillator 12. The voltage controlled crystal oscillator 12 oscillates an oscillation frequency based on the initial voltage value. The oscillation frequency obtained by the voltage controlled crystal oscillator 12 is output to the frequency converter 3 (step ST16).

The frequency converter 3 converts the desired broadcast wave in the receive frequency to an intermediate frequency based on the oscillation frequency obtained from the voltage controlled crystal oscillator 12, and continues the receiving operation (step ST18).

Thereafter, it is checked whether or not the receiving operation has been ended, or whether or not the power has been turned off (step ST19), and if the reception has not been ended or the power has not yet been turned off, the process flows to step ST15.

In step ST15, it is checked whether or not an error has been detected by the automatic frequency controller 8. In this case, time has elapsed since the initial start-up time and an error has been detected by the automatic frequency controller 8, so the process flows to step ST17.

In step ST17, the system controller 10 connects the automatic frequency controller 8 and the control voltage converter circuit 15 via the selector switch 13, and the control voltage converter circuit 15 generates a control voltage value based on the control signal that is output from the automatic frequency controller 8. The control voltage value is converted to an analog control voltage value by the D/A converter 11, and output to the voltage controlled crystal oscillator 12 (step ST17).

In the voltage controlled crystal oscillator 12, an oscillation frequency is oscillated based on the control voltage value, and output to the frequency converter 3 to continue the receiving operation (step ST18).

Then, if the reception has been ended or the power has been turned off as a result of the check in step ST19, the system controller 10 accesses the memory 14 to store the error information detected by the automatic frequency controller 8 in the memory 14, terminating the frequency receiving operation (step ST20).

As described above, in accordance with the first embodiment for carrying out the invention, a construction is provided in which various error information of the previous receive frequency is stored in the memory 14, and, at the next initial starting of the digital broadcasting receiver, initial value correcting calculator 16 corrects the initial value and calculates a new initial value by using the error information stored in the memory 14, and the control voltage converter circuit 15 converts the obtained initial value to an initial voltage value, and supplies it to the voltage controlled crystal oscillator 12 to control the oscillation frequency of the voltage controlled crystal oscillator 12, so that there is an effect that the variation in the oscillation frequency of the voltage controlled crystal oscillator 12 and the variation in the oscillation frequency due to temperature can be corrected to quickly perform the start-up of the digital broadcasting receiver.

### Second Embodiment

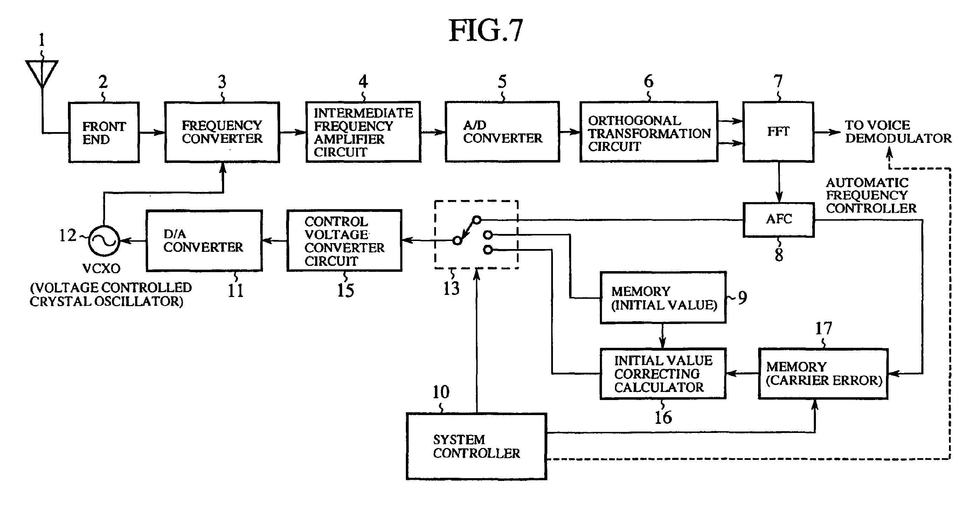

Fig. 7 is a block diagram showing the digital broadcasting receiver according to the second embodiment of the present invention, and in the figure, 17 is a memory for storing a carrier error. Since the other structural elements are same as those of the digital broadcasting receiver of the first embodiment of the present invention shown in Fig. 5, the same reference symbols are used, and the description of them is omitted here.

Now, the operation is described.

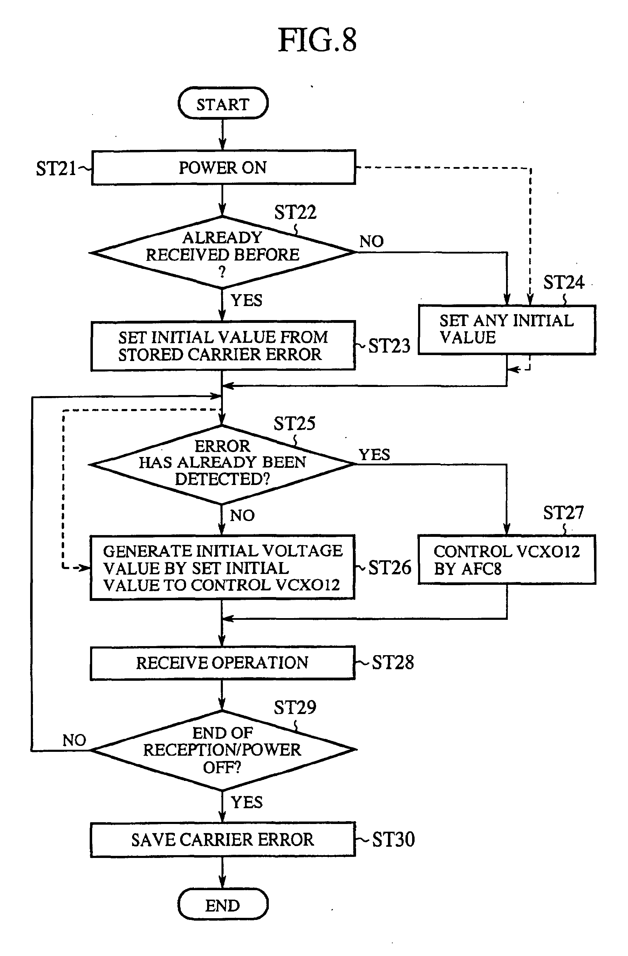

Fig. 8 is a flowchart showing the operation of the digital broadcasting receiver according to the second embodiment, which is shown in Fig. 7.

The power of the digital broadcasting receiver is turned on (step ST21), and a receive frequency is received through the antenna 1, and output through the front end 2, the frequency converter 3, the intermediate frequency amplifier circuit 4, the A/D converter 5, and the orthogonal transformation circuit 6 to the fast Fourier transform circuit 7. And, the operation until the automatic frequency controller 8 inputs control data for tuning the receive frequency that is output from the fast Fourier transform circuit 7 is same as the conventional digital broadcasting receivers shown in Fig. 1 and Fig. 3.

Then, the system controller 10 checks whether or not the digital broadcasting receiver has obtained the receive frequency before (step ST22). That is, at the initial start-up such as power-on, if no receive frequency has been received before, the system controller 10 connects the memory 9 and the control voltage converter circuit 15 via the selector switch 13 to output a given initial value previously stored in the memory 9 to the control voltage converter circuit 15 (step ST24).

On the other hand, if, at the initial start-up such as power-on, a receive frequency has been received before, the process flows to step ST23. In step ST23, system controller 10 connects the initial value correcting calculator 16 and the control voltage converter circuit 15 through the selector switch 13, and also accesses the memory 17 so that the carrier error stored in the memory 17 can be input to the initial value correcting calculator 16. This allows the carrier error read out from the memory 17 to be input to the initial value correcting calculator 16, which corrects the initial value input from the memory 9 based on the carrier error to calculate a new initial value (step ST23).

In the next step ST25, it is checked whether or not an error has been detected by the automatic frequency controller 8. In this case, since it is the initial start-up time and no error has been detected by the automatic frequency controller 8, the process flows to step ST26.

In step ST26, the control voltage converter circuit 15 has input thereto the initial value output from the memory 9 or the initial value output from the initial value correcting calculator 16 via the selector switch 13, and converts it to an initial voltage value. Thereafter, the initial voltage value, converted to an analog value by the D/A converter 11, is output to the voltage controlled crystal oscillator 12. The voltage controlled crystal oscillator 12 oscillates an oscillation frequency based on the initial voltage value. The oscillation frequency obtained by the voltage controlled crystal oscillator 12 is output to the frequency converter 3 (step ST26).

The frequency converter 3 converts the desired broadcast wave in the receive frequency to an intermediate frequency based on the oscillation frequency obtained from the voltage controlled crystal oscillator 12, and continues the receive operation (step ST28).

Thereafter, it is checked whether or not the receive operation has been ended, or whether or not the power has been turned off (step ST29), and if the reception has not been ended or the power has not yet been turned off, the process returns to step ST25.

In this case, time has elapsed since the initial start-up time and an error has been detected by the automatic frequency controller 8, so that the process flows to step ST27 (step ST25).

In step ST27, the system controller 10 connects the automatic frequency controller 8 and the control voltage converter circuit 15 via the selector switch 13, and the control voltage converter circuit 15 generates a control voltage value based on the control signal that is output from the automatic frequency controller 8. The control voltage value is converted to an analog control voltage value by the D/A converter 11, and output to the voltage controlled crystal oscillator 12 (step ST27).

In the voltage controlled crystal oscillator 12, an oscillation frequency is oscillated based on the control voltage value, and output to the frequency converter 3 to continue the receive operation (step ST28).

Then, if the reception has been ended or the power has been turned off as a result of the check in step ST29, the system controller 10 accesses the memory 17 to store the error information detected by the automatic frequency controller 8 in the memory 17, terminating the frequency receive operation (step ST30).

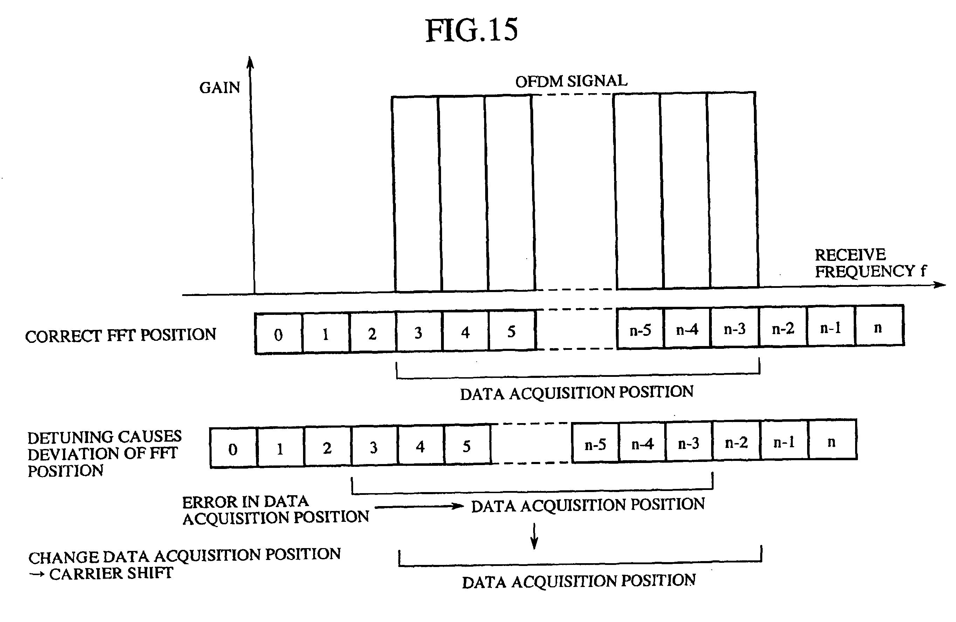

It is to be noted that the carrier error may be corrected by a carrier shift operation. Fig. 15 is an explanatory view showing the carrier shift operation, and in the figure, the ordinate represents gain (Gain), and the abscissa represents receive frequency (f).

The system controller 10 generates a control signal for carrier shift based on the carrier error read out from the memory 17, and outputs it to a voice demodulator (not shown). Thus, if detuning causes a positional shift of the fast Fourier transform circuit 7, to change the data acquisition position, the voice demodulator (not shown) operates according to the control signal to perform a carrier shift, thereby to obtain an optimum data acquisition position (step ST26).

In this case, in the voltage controlled crystal oscillator 12, a voltage control is carried out using the initial value obtained from the memory 9, and a control shown by a dotted line in Fig. 8 is performed.

As described above, in accordance with the second embodiment, a construction is provided in which the carrier error of the previous receive frequency is stored in the memory 17, and at the next initial starting of the digital broadcasting receiver, the initial value correcting calculator 16 corrects the initial value and calculates a new initial value by using the carrier error stored in the memory 17, and the control voltage converter circuit 15 converts the obtained initial value to an initial voltage value, and supplies it to the voltage controlled crystal oscillator 12 to control the oscillation frequency of the voltage controlled crystal oscillator 12, so that there is an effect that the variation in the oscillation frequency of the voltage controlled crystal oscillator 12 and the variation in the oscillation frequency due to temperature can be corrected to quickly start the digital broadcasting receiver.

### Third Embodiment

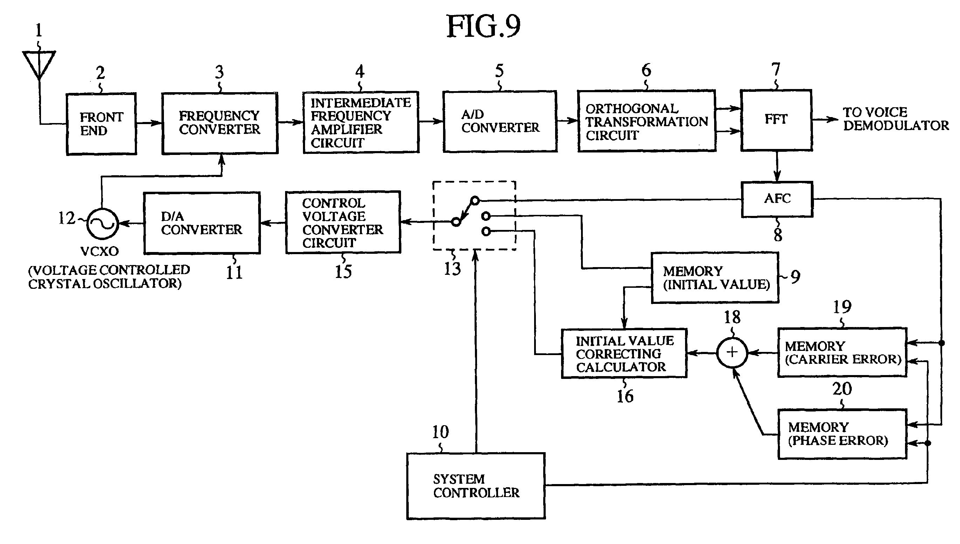

Fig. 9 is a block diagram showing the digital broadcasting receiver according to the third embodiment of the present invention, and in the figure, 19 is a memory for storing a carrier error, 20 is a memory for storing a phase error, and 18 is an arithmetic unit for adding the carrier error in the memory 19 and the phase error in the memory 20. Since the other structural elements are same as those of the digital broadcasting receiver of the first embodiment shown in Fig. 5, the same reference symbols are used, and the description of them is omitted here.

Now, the operation is described.

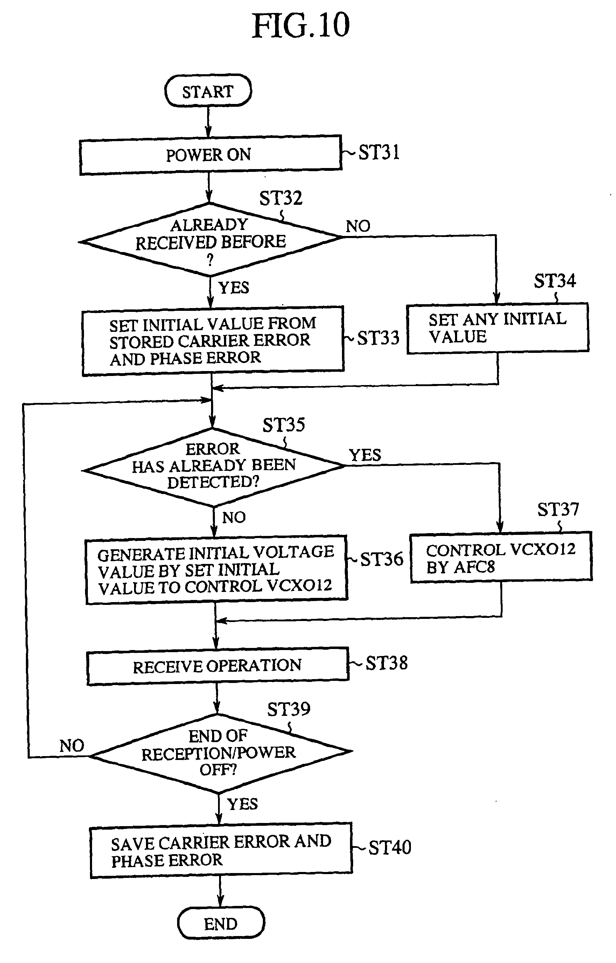

Fig. 10 is a flowchart showing the operation of the digital broadcasting receiver according to the third embodiment of the present invention shown in Fig. 9.

The power of the digital broadcasting receiver is turned on (step ST31), and a receive frequency is received through the antenna 1, and output through the front end 2, the frequency converter 3, the intermediate frequency amplifier circuit 4, the A/D converter 5, and the orthogonal transformation circuit 6 to the fast Fourier transform circuit 7. The operation until the automatic frequency controller 8 has input thereto the control data for tuning the receive frequency, which is output from the fast Fourier transform circuit 7, is same as the conventional digital broadcasting receivers shown in Fig. 1 and Fig. 3.

Then, the system controller 10 checks whether or not the digital broadcasting receiver has received a receive frequency before (step ST32). That is, at the initial start-up such as power-on, if no receive frequency has been received before, the system controller 10 connects the memory 9 and the control voltage converter circuit 15 via the selector switch 13 to output á given initial value previously stored in the memory 9 to the control voltage converter circuit 15 (step ST34).

On the other hand, if, at the initial start-up such as power-on, a receive frequency has been received before, the process flows to step ST33. In step ST33, system controller 10 connects the initial value correcting calculator 16 and the control voltage converter circuit 15 through the selector switch 13, and also accesses the memories 19 and 20 so that the carrier error stored in the memory 19 and the phase error stored in the memory 20 can be input to the arithmetic unit 18. This allows the arithmetic unit 18 to add the carrier error stored in the memory 19 and the phase error stored in the memory 20. The computation result of the arithmetic unit 18 is output to the initial value correcting calculator 16. And, the initial value correcting calculator 16 has input thereto the initial value in the memory 9 and the computation result in the arithmetic unit 18, and corrects the initial value in the memory 9 based on the computation result to calculate a new initial value (step ST33).

In the next step ST35, it is checked whether or not an error has been detected by the automatic frequency controller 8. In this case, since it is the initial start-up time and no error has been detected by the automatic frequency controller 8, the process flows to step ST36.

In step ST36, the control voltage converter circuit 15 has input thereto the initial value output from the memory 9 or the initial value output from the initial value correcting calculator 16 via the selector switch 13, and converts it to an initial voltage value. Thereafter, the initial voltage value, converted to an analog value by the D/A converter 11, is output to the voltage controlled crystal oscillator 12. The voltage controlled crystal oscillator 12 oscillates an oscillation frequency based on the initial voltage value. The oscillation frequency obtained by the voltage controlled crystal oscillator 12 is output to the frequency converter 3 (step ST36).

The frequency converter 3 converts the desired broadcast wave in the receive frequency to an intermediate frequency based on the oscillation frequency obtained from the voltage controlled crystal oscillator 12, and continues the receive operation (step ST38).

Thereafter, it is checked whether or not the receive operation has been ended, or whether or not the power has been turned off (step ST39), and if the reception has not been ended or the power has not yet been turned off, the process returns to step ST35.

In this case, time has elapsed since the initial start-up time and an error has been detected by the automatic frequency controller 8, so that the process flows to step ST37 (step ST35).

In step ST37, the system controller 10 connects the automatic frequency controller 8 and the control voltage converter circuit 15 via the selector switch 13, and the control voltage converter circuit 15 generates a control voltage value based on the control signal that is output from the automatic frequency controller 8. The control voltage value is converted to an analog control voltage value by the D/A converter 11, and output to the voltage controlled crystal oscillator 12 (step ST37).

In the voltage controlled crystal oscillator 12, an oscillation frequency is oscillated based on the control voltage value, and output to the frequency converter 3 to continue the receiving operation (step ST38).

Then, if the reception has been ended or the power has been turned off as a result of the check in step ST39, the system controller 10 accesses the memories 19 and 20 to store the carrier error and phase error detected by the automatic frequency controller 8 in the memory 19 and 20, terminating the frequency receiving operation (step ST40).

As described above, in accordance with the third embodiment, a construction is provided in which the carrier error and phase error of the previous receive frequency are stored in the memories 19 and 20, and at the next initial starting of the digital broadcasting receiver, the initial value correcting calculator 16 calculates a new initial value by using the carrier error and phase error stored in the memories 19 and 20, and the control voltage converter circuit 15 converts the initial value to an initial voltage value, and supplies it to the voltage controlled crystal oscillator 12 to control the oscillation frequency of the voltage controlled crystal oscillator 12, so that there is an effect that the variation in the oscillation frequency of the voltage controlled crystal oscillator 12 and the variation in the oscillation frequency due to temperature can be corrected to quickly start the digital broadcasting receiver.

### Fourth Embodiment

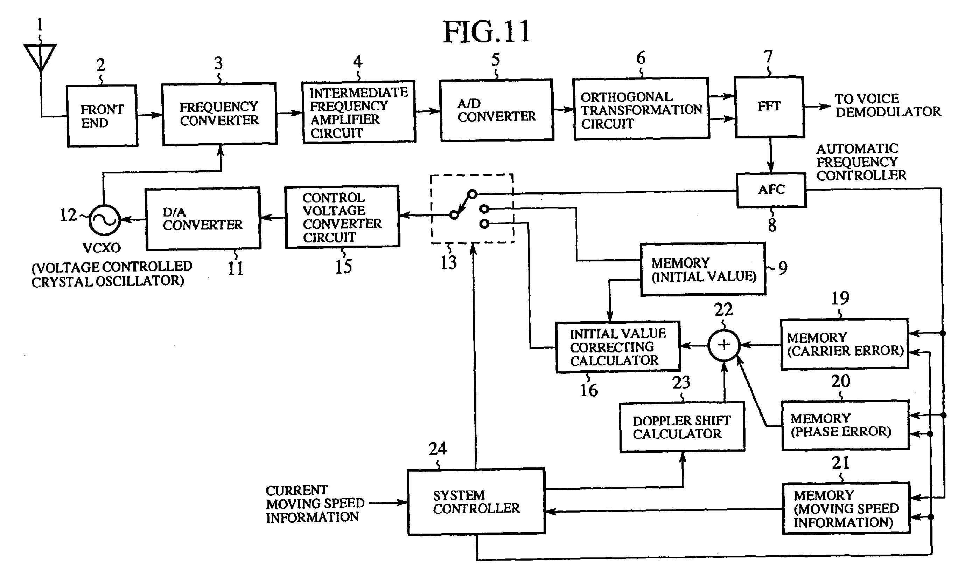

Fig. 11 is a block diagram showing the digital broadcasting receiver according to the fourth embodiment of the present invention, and in the figure, 21 is a memory 21, 23 is a Doppler shift calculator 23 which has input thereto moving speed information to perform a Doppler shift calculation, 22 is an arithmetic unit for adding the carrier error in the memory 19, the phase error in the memory 20, and the Doppler shift information obtained from the Doppler shift calculator 23, and 24 is a system controller. The other structural elements are same as those of the digital broadcasting receiver of the third embodiment of the present invention shown in Fig. 9, so that the description of them is omitted here.

Now, the operation is described.

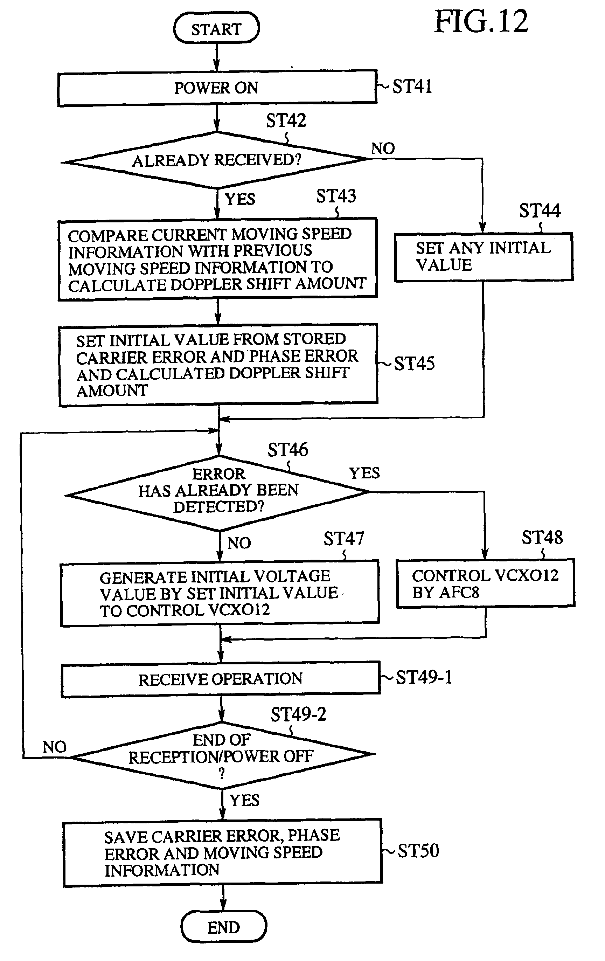

Fig. 12 is a flowchart showing the operation of the digital broadcasting receiver according to the fourth embodiment shown in Fig. 11.

The power of the digital broadcasting receiver is turned on (step ST41), and a receive frequency is received through the antenna 1, and output through the front end 2, the frequency converter 3, the intermediate frequency amplifier circuit 4, the analog-to-digital (A/D) converter 5, and the orthogonal transformation circuit 6 to the fast Fourier transform circuit 7. The operation until the automatic frequency controller 8 has input thereto the control data for tuning the receive frequency, which is output from the fast Fourier transform circuit 7, is same as the conventional digital broadcasting receivers shown in Fig. 1 and Fig. 3.

Then, the system controller 24 checks whether or not the digital broadcasting receiver has received a receive frequency before (step ST42). That is, at the initial start-up such as power-on, if no receive frequency has been received before, the system controller 24 connects the memory 9 and the control voltage converter circuit 15 via the selector switch 13 to output a given initial value previously stored in the memory 9 to the control voltage converter circuit 15 (step ST44).

On the other hand, if, at the initial start-up such as power-on, a receive frequency has been received before, the process flows to step ST43. In step ST43, system controller 24 compares the current moving speed information with the moving speed information stored at the previous reception time which is stored in the memory 21, and, for instance, if the digital broadcasting receiver is now moving, the system controller 24 outputs the differential information between the current moving speed information and the moving speed information in the memory 21 to the Doppler shift calculator 23, and if the digital broadcasting receiver is not moving, the system controller 24 outputs the moving speed information in the memory 21 to the Doppler shift calculator 23. The Doppler shift calculator 23 calculates the Doppler shift amount based on the moving speed information obtained from the system controller 24, and outputs it to the arithmetic unit 22 (step ST43).

Then, in the step ST45, the memories 19 and 20 are accessed so that the carrier error stored in the memory 19 and the phase error stored in the memory 20 can be input to the arithmetic unit 22. Due to this, the arithmetic unit 22 adds the carrier error in the memory 19, the phase error in the memory 20, and the Doppler shift amount obtained from the Doppler shift calculator 23. Further, the system controller 24 connects the initial value correcting calculator 16 and the control voltage converter circuit 15 through the selector switch 13. And, the computation result of the arithmetic unit 22 is output to the initial value correcting calculator 16. This allows the initial value in the memory 9 and the computation result in the arithmetic unit 22 to be input to the initial value correcting calculator 16, which in turn corrects the initial value in the memory 9 to calculate a new initial value (step ST45).

In the next step ST46, it is checked whether or not an error has been detected by the automatic frequency controller 8. In this case, since it is the initial start-up time and no error has been detected by the automatic frequency controller 8, the process flows to step ST47.

In step ST47, the control voltage converter circuit 15 converts the initial value output from the memory 9 or the initial value correcting calculator 16 via the selector switch 13 to an initial voltage value. And, the initial voltage value is converted to an analog value by the D/A converter 11, and output to the voltage controlled crystal oscillator 12. The voltage controlled crystal oscillator 12 oscillates an oscillation frequency based on the initial voltage value. The oscillation frequency obtained by the voltage controlled crystal oscillator 12 is output to the frequency converter 3. The frequency converter 3 converts the desired broadcast wave in the receive frequency to an intermediate frequency based on the oscillation frequency obtained from the voltage controlled crystal oscillator 12, and continues the receiving operation (step ST49-1).

Thereafter, it is checked whether or not the receiving operation has been ended, or whether or not the power has been turned off (step ST49-2), and if the reception has not been ended or the power has not yet been turned off, the process returns to step ST46.

In this case, time has elapsed since the initial start-up and an error has been detected by the automatic frequency controller 8, so the process flows to step ST48 (step ST46).

In step ST48, the system controller 24 connects the automatic frequency controller 8 and the control voltage converter circuit 15 via the selector switch 13, and the control voltage converter circuit 15 generates a control voltage value based on the control signal that is output from the automatic frequency controller 8. The control voltage value is converted to an analog control voltage value by the D/A converter 11, and output to the voltage controlled crystal oscillator 12 (step ST48).

In the voltage controlled crystal oscillator 12, an oscillation frequency is oscillated based on the control voltage value, and output to the frequency converter 3 to continue the receive operation (step ST49-1).

Then, if the reception has been ended or the power has been turned off as a result of the check in step ST49-2, the system controller 24accesses the memories 19, 20 and 21 to respectively store the carrier error, phase error, and moving speed information detected by the automatic frequency controller 8 in the memories 19, 20 and 21, terminating the frequency receiving operation (step ST50).

As described above, in accordance with the fourth embodiment, a construction is provided in which the carrier error, phase error, and moving speed information of the previous receive frequency are stored in the memories 19, 20 and 21, respectively and at the next initial starting of the digital broadcasting receiver, the initial value correcting calculator 16 corrects the initial value to calculate a new initial value by using the carrier error, phase error, and moving speed information which are stored in the memories 19, 20 and 21, respectively, and the control voltage converter circuit 15 converts the initial value to an initial voltage value, and supplies it to the voltage controlled crystal oscillator 12 to control the oscillation frequency of the voltage controlled crystal oscillator 12, so that there is an effect that the variation in the oscillation frequency of the voltage controlled crystal oscillator 12 and the variation in the oscillation frequency due to temperature can be corrected to quickly start the digital broadcasting receiver even for a change in the receive state during a standstill or move.

### Fifth Embodiment

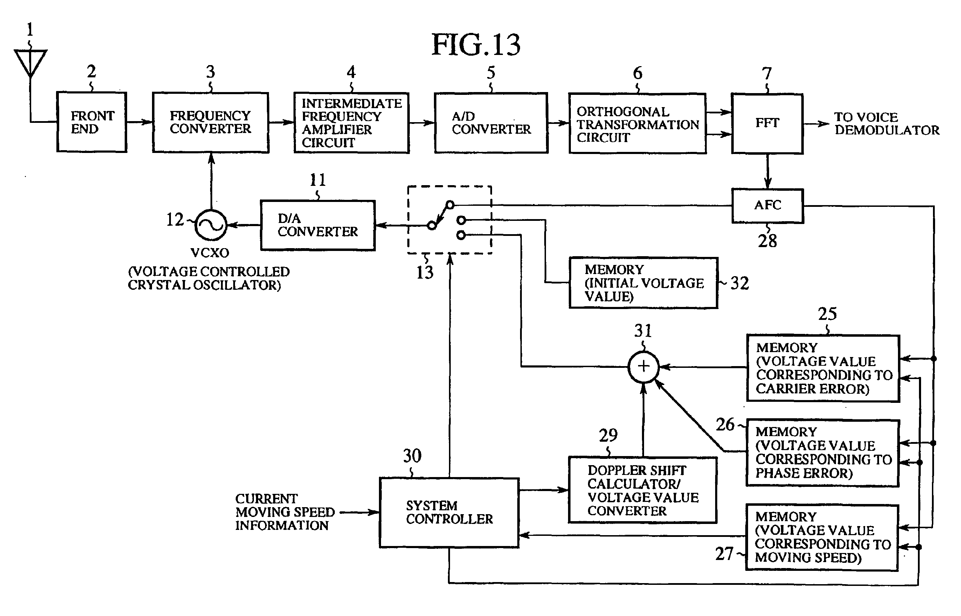

Fig. 13 is a block diagram showing the digital broadcasting receiver according to the fifth embodiment of the present invention, and in the figure, 25 is a memory for storing a voltage value corresponding to the carrier error, 26 is a memory for storing a voltage value corresponding to the phase error, 27 is a memory for storing a voltage value corresponding to the moving speed, 28 is an automatic frequency controller (AFC), 29 is a Doppler shift calculator/voltage converter which inputs moving speed information to perform a Doppler shift calculation, and calculates a voltage value based on the obtained calculation result, 30 is a system controller, 31 is an arithmetic unit for performing an addition, and 32 is a memory in which the initial value for the control voltage value is stored. Since the other structural elements are same as those of the digital broadcasting receiver of the fourth embodiment shown in Fig. 11, the same reference symbols are used, and the description of them is omitted here.

Now the operation is described.

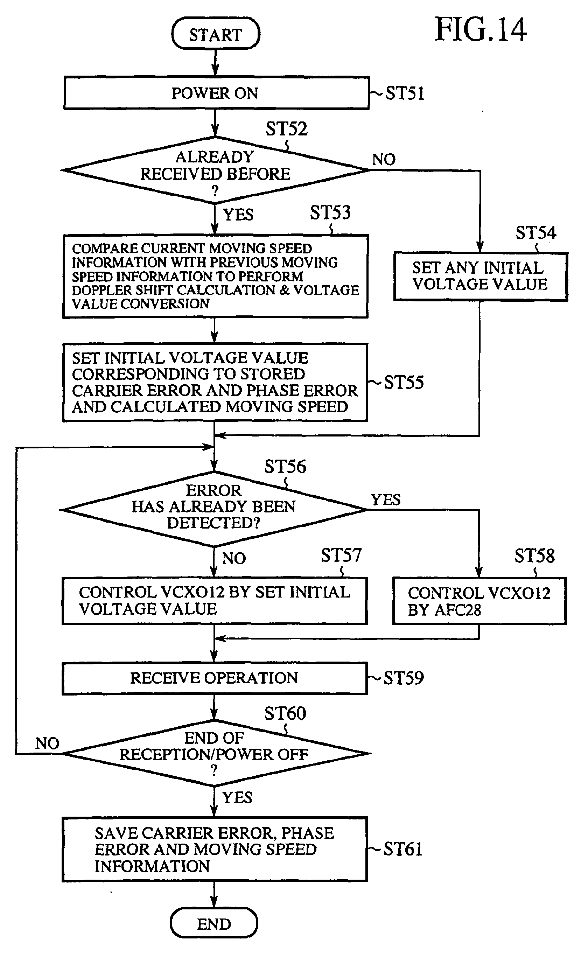

Fig. 14 is a flowchart showing the operation of the digital broadcasting receiver according to the fifth embodiment shown in Fig. 13.

The power of the digital broadcasting receiver is turned on (step ST51), and a receive frequency is obtained through the antenna 1, and output through the front end 2, the frequency converter 3, the intermediate frequency amplifier circuit 4, the analog-to-digital (A/D) converter 5, and the orthogonal transformation circuit 6 to the fast Fourier transform circuit 7.

The operation until the automatic frequency controller 28 has input thereto the control data for tuning the receive frequency, which is output from the fast Fourier transform circuit 7, is same as the conventional digital broadcasting receivers shown in Fig. 1 and Fig. 3.

Then, the system controller 30 checks whether or not the digital broadcasting receiver has received a receive frequency before (step ST52). That is, at the initial start-up such as power-on, if no receive frequency has been received before, the system controller 30 connects the memory 32 and the D/A converter 11 via the selector switch 13 to output a given initial voltage value previously stored in the memory 32 to the D/A converter 11 (step ST54).

On the other hand, if, at the initial start-up such as power-on, a receive frequency has been received before, the process flows to step ST53. In step ST53, system controller 30 compares the current moving speed information with the moving speed information stored in the memory 27 at the previous reception time, and, for instance, if the digital broadcasting receiver is now moving, the system controller 30 outputs the current moving speed information to the Doppler shift calculator/voltage value converter 29, and if the digital broadcasting receiver is not moving, the system controller 30 outputs the moving speed information corresponding to the voltage value in the memory 27 to the Doppler shift calculator/voltage value converter 29.

The Doppler shift calculator/voltage value converter 29 calculates the Doppler shift amount based on the moving speed information obtained from the system controller 30, and outputs it to the arithmetic unit 31(step ST53).

Then, in the step ST55, the system controller 30 accesses the memories 25 and 26 so that the arithmetic unit 31 can read out the voltage value corresponding to the carrier error, which is stored in the memory 25, and the voltage value corresponding to the phase error, which is stored in the memory 20. By this, the arithmetic unit 31adds the voltage value corresponding to the carrier error in the memory 25, the voltage value corresponding to the phase error in the memory26, and the Doppler shift amount obtained from the Doppler shift calculator/voltage value converter 29 to calculate a initial voltage value (step ST55).

In the next step ST56, it is checked whether or not an error has been detected by the automatic frequency controller 28. In this case, since it is the initial start-up time and no error has been detected by the automatic frequency controller 28, the process flows to step ST57.

In step ST57, the initial voltage value in the memory 32 or the initial voltage is converted to an analog value by the D/A converter 11, and output to the voltage controlled crystal oscillator 12.

The voltage controlled crystal oscillator 12 oscillates an oscillation frequency based on the initial voltage value. The oscillation frequency obtained by the voltage controlled crystal oscillator 12 is output to the frequency converter 3. The frequency converter 3 converts the desired broadcast wave in the receive frequency to an intermediate frequency based on the oscillation frequency obtained from the voltage controlled crystal oscillator 12, and continues the receiving operation (step ST59).

Thereafter, it is checked whether or not the receiving operation has been ended, or whether or not the power has been turned off (step ST60), and if the reception has not been ended or the power has not yet been turned off, the process returns to step ST56.

In this case, time has elapsed since the initial start-up and an error has been detected by the automatic frequency controller 8, so that the process flows to step ST58 (step ST56).

In step ST58, the system controller 30 connects the automatic frequency controller 28 and the D/A converter 11 via the selector switch 13. This allows the control voltage value output from the automatic frequency controller 28 to be converted to an analog control voltage value by the D/A converter 11, and output to the voltage controlled crystal oscillator 12 (step ST58).

In the voltage controlled crystal oscillator 12, an oscillation frequency is oscillated based on the control voltage value, and output to the frequency converter 3 to continue the receive operation (step ST59).

Then, if the reception has been ended or the power has been turned off as a result of the check in step ST60, the system controller 30 accesses the memories25, 26 and 27 to store the voltage value corresponding to the carrier error, the voltage value corresponding to the phase error, and the voltage value corresponding to the moving speed information, which are obtained by the automatic frequency controller 8, in the memories 25, 26 and 27, respectively, terminating the frequency receive operation (step ST61).

As described above, in accordance with the fifth embodiment, a construction is provided in which the voltage value corresponding to the carrier error, the voltage value corresponding to the phase error, and the voltage value corresponding to the moving speed information of the previous receive frequency are stored in the memories25, 26 and 27, and at the initial starting of the digital broadcasting receiver, the arithmetic unit 31 calculates a initial voltage value by using the voltage value corresponding to the carrier error, the voltage value corresponding to the phase error, and the voltage value corresponding to the moving speed information stored in the memories25, 26 and 27, and supplies it to the automatic frequency controller 12 to control the oscillation frequency of the automatic frequency controller 12, so that there is an effect that the variation in the oscillation frequency of the voltage controlled crystal oscillator 12 and the variation in the oscillation frequency due to temperature can be corrected to quickly start the digital broadcasting receiver even for a change in the receive state during a standstill or move.

### Industrial Applicability

As described above, since the digital broadcasting receiver related to this invention enables the variation in the oscillation frequency to be corrected according to change in the receiving state during a standstill or running, or change in the environment such as the surrounding temperature in order to perform the tuning to a desired frequency, and thereby to shorten the starting time, it can be applied to mobile units such as automobiles, aircraft, or trains.

## Claims

1. A digital broadcasting receiver comprising:
a local oscillator for varying the oscillation frequency based on a supplied control voltage value;
an automatic frequency controller for generating said control voltage value based on a receive frequency for tuning to said receive frequency, and outputting it to said local oscillator;
memory means for storing error information of the previously received receive frequency and an initial value corresponding to the initial voltage value for the initial start-up; and
control means for reading out said error information and said initial value stored in said memory means at the initial start-up, correcting said initial value based on said error information, generating said initial voltage value for the start-up based on said corrected initial value, outputting said initial voltage value to said local oscillator, and accessing said memory means at the end of reception to store said error information corresponding to the receive frequency generated in said automatic frequency controller in said memory means.

2. The digital broadcasting receiver according to claim 1 wherein said memory means stores the carrier error of the previously received receive frequency and an initial value corresponding to the initial voltage value for the initial start-up;
said control means reads out, at the initial start-up, said carrier error and said initial value which are stored in said memory means, corrects said initial value based on said carrier error, generates said initial voltage value for the start-up based on said corrected initial value, and outputs said generated initial voltage value to said local oscillator; and
said control means further accesses said memory means at the end of the reception to store said carrier error corresponding to the receive frequency generated in said automatic frequency controller in said memory means.

3. The digital broadcasting receiver according to claim 1 wherein said memory means stores the carrier error and phase error of the previously received receive frequency, and an initial value corresponding to the initial voltage value for the initial start-up;
said control means reads out, at the initial start-up, said carrier error, said phase error, and said initial value, which are stored in said memory means, corrects said initial value based on said carrier error and said phase error, generates said initial voltage value for the start-up based on said corrected initial value, and outputs said generated initial voltage value to said local oscillator; and
said control means further accesses said memory means at the end of the reception to store said carrier error and said phase error related to the receive frequency generated in said automatic frequency controller in said memory means.

4. The digital broadcasting receiver according to claim 1 wherein said memory means stores the carrier error, phase error, and moving speed information of the previously received receive frequency, and an initial value corresponding to the initial voltage value for the initial start-up;
said control means reads out said carrier error, said phase error, said moving speed information, and said initial value, which are stored in said memory means, corrects said initial value based on said carrier error, said phase error, and said moving speed information, generates said initial voltage value for the start-up based on said corrected initial value, and outputs said generated initial voltage value to said local oscillator; and
said control means further accesses said memory means at the end of the reception to store said carrier error, said phase error, and said moving speed information related to the receive frequency generated in said automatic frequency controller in said memory means.

5. The digital broadcasting receiver according to claim 1 wherein said memory means stores a voltage value corresponding to the carrier error of the previously received receive frequency, a voltage value corresponding to the phase error thereof, and a voltage value corresponding to the moving speed information thereof, and an initial voltage value for the initial start-up;
said control means reads out, at the initial start-up, the voltage value corresponding to said carrier error, the voltage value corresponding to said phase error, the voltage value corresponding to said moving speed information, and said initial voltage value, which are stored in said memory, corrects the initial voltage value based on the voltage value corresponding to said carrier error, the voltage value corresponding to said phase error, and the voltage value corresponding to said moving speed information, and outputs the said obtained initial voltage value to said local oscillator; and
said control means further accesses said memory means at the end of the reception to store the voltage value corresponding to said carrier error related to the receive frequency generated in said automatic frequency controller, the voltage value corresponding to said phase error, and the voltage value corresponding to said moving speed information, in said memory means.
